# EUROPEAN PATENT SPECIFICATION

(11) **EP 4 083 897 B1**
(45) Date of publication and mention of the grant of the patent: **06.05.2026**
(21) Application number: 20904809.9
(22) Date of filing: 27.11.2020
(51) Int. Cl.: G06Q 10/06, G06F 30/13, G06Q 50/08

(54) **DATA MANAGEMENT SYSTEM, MANAGEMENT METHOD, AND MANAGEMENT PROGRAM**
DATENVERWALTUNGSSYSTEM, VERWALTUNGSVERFAHREN UND VERWALTUNGSPROGRAMM
SYSTÈME DE GESTION DE DONNÉES, PROCÉDÉ DE GESTION ET PROGRAMME DE GESTION

(30) Priority: 23.12.2019 JP 2019231284
(43) Date of publication of application: 02.11.2022
(73) Proprietor: TOPCON CORPORATION, Tokyo 174-8580 (JP)
(72) Inventor: DOJI, Atsushi, Tokyo 174-8580 (JP); YAMADA, Toshio, Tokyo 174-8580 (JP); NISHITA, Nobuyuki, Tokyo 174-8580 (JP); YANOBE, Satoshi, Tokyo 174-8580 (JP); KANEKO, Junki, Tokyo 174-8580 (JP)
(74) Representative: dompatent
(86) International application number: PCT/JP2020/044195
(87) International publication number: WO 2021/131489

(56) References cited:
- JP-A- 2012 022 551
- JP-A- 2017 204 222
- US-A1- 2003 004 645
- TOMITA, HIROYUKI; SAKAMOTO, SHINTARO: "Equipment construction which used BIM", HEATING, AIR-CONDITIONING AND SANITARY ENGINEERING , vol. 86, no. 5, 5 May 2012 (2012-05-05), JP , pages 39 - 43, XP009537230, ISSN: 0386-4081

## Description

### Technical Field

The present invention relates to a system, method, and program for managing data for design and construction of a construction object.

### Background Art

In recent years, in the field of construction, utilization of a 3D model called BIM (Building Information Modeling) has been promoted. BIM has been increasingly utilized at design sites, that is, planning, architectural design, facility design, design analysis, execution design, construction planning, and component manufacturing. For example, Japanese Published Unexamined Patent Application No. 2019-21190 discloses a technology for utilizing BIM at manufacturing sites of members at a plant. US 2003/004645 describes a prior art construction management system.

### Summary of Invention

### Technical Problem

However, at construction sites, utilization of BIM has been delayed, and a technology for coordinating an actual construction status with BIM has been desired. In addition, it frequently occurs that on-site construction processes do not proceed according to original designs, and therefore, data management to reflect an actual construction status in upstream drawings and turn it over to downstream construction processes is also desired. Furthermore, at a construction site, there are some members that are not included in design BIM but are necessary for construction, and data management to consider such members including their influences is also desired.

The present invention was made in view of these problems, and an object thereof is to realize data management to reflect an actual construction status in the upstream or downstream process.

### Solution to Problem

The present invention is defined in the independent claims.

In order to solve the problems described above, a management method according to an aspect of the present invention includes, by transmitting and receiving information to and from databases, where the databases include:
a design database recording design data of construction members constituting a construction object, a measurement database recording measurement data of the construction members, and a construction database storing construction data of the construction members, a step (A) of selecting a construction member from the construction database, a step (B) of creating a design model of the construction member from design data of the construction member in the design database, a step (C) of selecting a peripheral member peripheral to the construction member from the design database, a step (D) of creating a measurement model of the peripheral member from measurement data of the peripheral member in the measurement database, a step (E) of creating a design corrected model by synthesizing the design model and the measurement model and correcting the shape and/or coordinates of the design model, in accordance with a shape of the measurement model;
a step (F) of selecting a construction designated member for which a construction plan is corrected based on the design corrected model, and a step (G) of recording, with respect to the construction designated member, coordinates and a shape of the design corrected model as construction designated member coordinates and a construction designated member shape, and construction content of the construction designated member as construction inspection content, in a corrected construction plan database.

In the aspect described above, it is also preferable that, further, by transmitting and receiving information to and from a member database recording member basic data of the construction members, before the step (E), whether the construction member and the peripheral member are movable members is determined by referring to the member database, and when the member is determined to be unmovable, the design corrected model is created in the step (E), and when the member is determined to be movable, movability information of the movable member is read from the member database and a movable model of the movable member is created, and a design corrected model is created by synthesizing the design model or the measurement model with the movable model, and the processing shifts to the step (F), and in the step (G), by further referring to the member database, construction influenced portion information based on the movability information of the movable member is recorded in the corrected construction plan database.

In the aspect described above, it is also preferable that the management method further includes a step of writing the construction designated member coordinates and the construction designated member shape of the construction designated member recorded in the corrected construction plan database over member coordinates and a member shape linked by member identification information of the construction designated member in the design database.

In the aspect described above, it is also preferable that the management method further includes a step of newly adding the construction designated member, the construction designated member coordinates, and the construction designated member shape recorded in the corrected construction plan database into the design database.

A management program describing the management method according to the aspect described above as a computer program and enabling execution of the management method is also preferable.

In order to solve the problems described above, a management system according to an aspect of the present invention includes a design database recording design data of construction members constituting a construction object, a measurement database recording measurement data of the construction members, a construction database storing construction data of the construction members, a construction member selecting unit configured to select a construction member from the construction database, a peripheral member selecting unit configured to select a peripheral member peripheral to the construction member from the design database, a model creating unit configured to create a design model of the construction member from the design data of the construction member, and a measurement model of the peripheral member from the measurement data of the peripheral member, a corrected model creating unit configured to create a design corrected model by synthesizing the design model and the measurement model and correcting the shape and/or coordinates of the design model, in accordance with a shape of the measurement model, and a corrected construction plan creating unit configured to select a construction designated member for which a construction plan is corrected based on the design corrected model, and record, with respect to the construction designated member, coordinates and a shape of the design corrected model as construction designated member coordinates and a construction designated member shape, and construction content of the construction designated member as construction inspection content, in a corrected construction plan database.

In the aspect described above, it is also preferable that the management system further includes a member database recording member basic data of the construction members, and a member movability determining unit configured to determine whether the construction member and the peripheral member are movable members by referring to the member database, and when determining that the member is movable, read movability information of the movable member from the member database and create a movable model of the movable member, wherein the corrected model creating unit creates a design corrected model by synthesizing the design model or the measurement model with the movable model, and the corrected construction plan creating unit refers to the member database and further records construction influenced portion information based on the movability information of the movable member in the corrected construction plan database.

In order to solve the problems described above, a management system according to another aspect of the present invention includes a design database recording design data of construction members constituting a construction object, a measurement database recording measurement data of the construction members, a member database recording member basic data of the construction members, a construction database storing construction data of the construction members, a construction member selecting unit configured to select a construction member from the construction database, a peripheral member selecting unit configured to select a peripheral member peripheral to the construction member from the design database, a model creating unit configured to create a measurement model of the peripheral member based on the measurement data in the measurement database, a basic shape model creating unit configured to create a basic shape model of the construction member from the member basic data in the member database and the construction data in the construction database, a corrected model creating unit configured to create a design corrected model by synthesizing the measurement model and the basic shape model, and a corrected construction plan creating unit configured to select a construction designated member for which a construction plan is corrected based on the design corrected model, and record, with respect to the construction designated member, coordinates and a shape of the design corrected model as construction designated member coordinates and a construction designated member shape, and construction content of the construction designated member as construction inspection content, in a corrected construction plan database.

In the aspect described above, it is also preferable that the management system further includes a member movability determining unit configured to determine whether the construction member and the peripheral member are movable members by referring to the member database, and when determining that the member is movable, read movability information of the movable member from the member database and create a movable model of the movable member, wherein the corrected model creating unit creates a design corrected model by synthesizing the measurement model, the basic shape model, and the movable model, and the corrected construction plan creating unit refers to the member database and further records construction influenced portion information based on the movability information of the movable member in the corrected construction plan database.

In the aspect described above, it is also preferable that the management system further includes a corrected construction plan reflecting unit configured to write the construction designated member coordinates and the construction designated member shape of the construction designated member recorded in the corrected construction plan database over member coordinates and a member shape linked by member identification information of the construction designated member in the design database.

In the aspect described above, it is also preferable that the management system further includes a corrected construction plan reflecting unit configured to newly add the construction designated member, the construction designated member coordinates, and the construction designated member shape recorded in the corrected construction plan database into the design database.

### Advantageous Effects of Invention

According to the data management system, management method, and management program of the present invention, data management to reflect an actual construction status in the upstream or downstream data is realized.

### Brief Description of Drawings

Fig. 1 is a block diagram illustrating a configuration of a management system according to a first embodiment of the present invention.
Fig. 2 is a diagram illustrating an example of a design database according to the management system.
Fig. 3 is a diagram illustrating an example of a measurement database according to the management system.
Fig. 4 is a diagram illustrating an example of a construction database according to the management system.
Fig. 5 is a diagram illustrating an example of a corrected construction plan database according to the management system.
Fig. 6 is a management flowchart illustrating a management method according to the first embodiment of the present invention.
Fig. 7 is a work image view of the management flow.
Fig. 8 is a configuration block diagram of a management system according to a second embodiment of the present invention.
Fig. 9 is a diagram illustrating an example of a member database according to the management system.
Fig. 10 is a diagram illustrating an example of a construction database according to the management system.
Fig. 11 is a diagram illustrating an example of a corrected construction plan database according to the management system.
Fig. 12 is a management flowchart illustrating a management method according to the second embodiment of the present invention.
Fig. 13 is a configuration block diagram of a management system according to a third embodiment of the present invention.
Fig. 14 is a management flowchart illustrating a management method according to the third embodiment of the present invention.
Fig. 15 is a work image view of the management flow.
Fig. 16 is a configuration block diagram of a management system according to a fourth embodiment of the present invention.
Fig. 17 is a management flowchart illustrating a management method according to the fourth embodiment of the present invention.
Fig. 18 is a configuration block diagram of a management system according to a fifth embodiment of the present invention.
Fig. 19 is a management flowchart illustrating a management method according to the fifth embodiment of the present invention.
Fig. 20 is a work image view of the management flow.
Fig. 21 is a configuration block diagram of a management system according to a sixth embodiment of the present invention.
Fig. 22 is a management flowchart illustrating a management method according to the sixth embodiment of the present invention.
Fig. 23 is a work image view of the management flow.

### Description of Embodiments

Next, preferred embodiments of the present invention will be described with reference to the drawings.

### <First Embodiment>

### (Configuration of Management System According to First Embodiment)

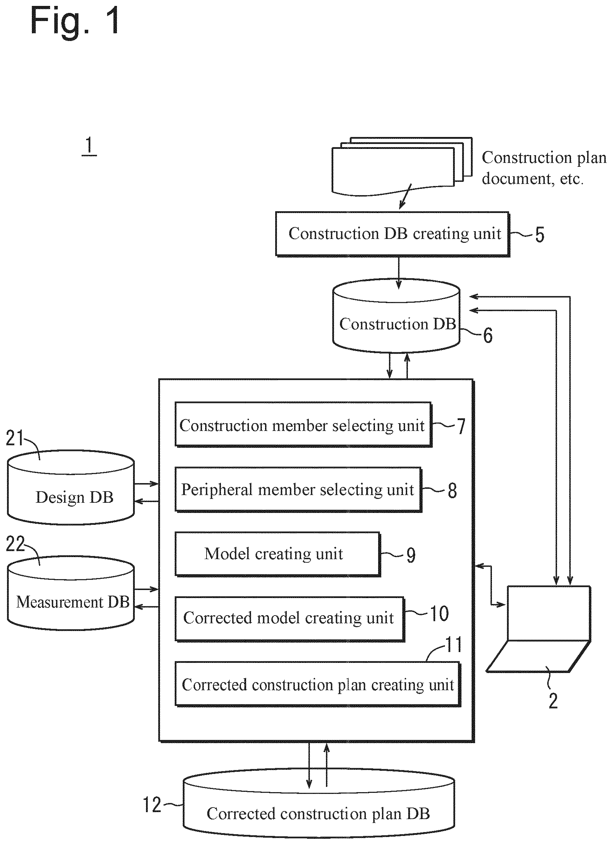

Fig. 1 is a configuration block diagram of a management system 1 according to a first embodiment of the present invention. The management system 1 includes an input/output device 2, a construction database 6, a construction member selecting unit 7, a peripheral member selecting unit 8, a model creating unit 9, a corrected model creating unit 10, a corrected construction plan creating unit 11, and a corrected construction plan database 12, and uses, as data serving as materials, a design database 21 and a measurement database 22.

The input/output device 2 is a general-purpose personal computer, tablet terminal, etc., including at least a computing unit, a storage unit, a communication unit, a display unit, and an operation unit, and can be operated by an administrator.

The respective functional units of the construction member selecting unit 7, the peripheral member selecting unit 8, the model creating unit 9, the corrected model creating unit 10, and the corrected construction plan creating unit 11 are configured by electronic circuits such as a CPU (Central Processing Unit), an ASIC (Application Specific Integrated Circuit), and a PLD (Programmable Logic Device) such as an FPGA (Field Programmable Gate Array). Each functional unit may be configured inside the input/output device 2 or by either separate external hardware/software. In the latter case, each functional unit can transmit and receive information to and from the input/output device 2 through a network.

The construction database 6, the design database 21, the measurement database 22, and the corrected construction plan database 12 are stored in a server computer with which communication can be made through a network. The server computer can communicate with related functional units, and can transmit and receive information.

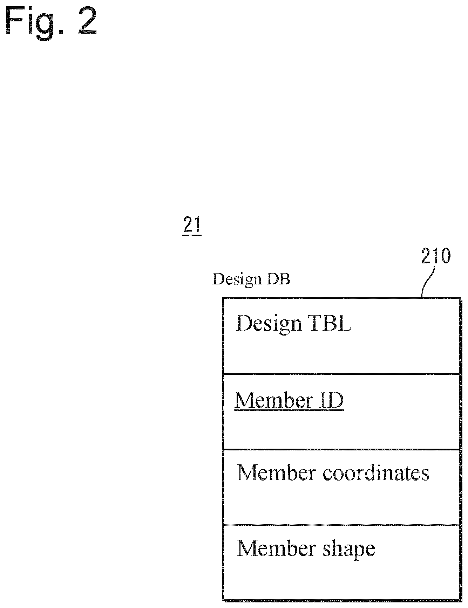

In the design database 21, design data based on design BIM (data on each construction member constituting the construction object in the form of 3D model, the 3D model includes shapes of surfaces, lines, and points) of a construction object as a management object is stored. The design database 21 stores a design table 210 in which, at least, as illustrated in Fig. 2, with respect to each construction member, member identification information (hereinafter, referred to as member ID), member coordinates, and a member shape are associated with each other.

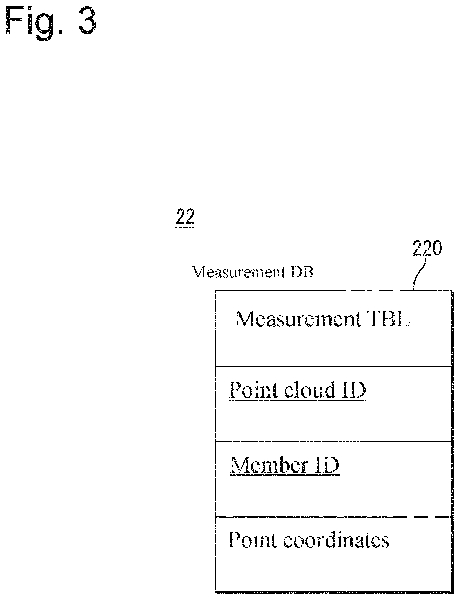

In the measurement database 22, measurement data (point cloud data in which coordinate information is registered, point data, screen data holding coordinate information of measurement spots, and data on construction errors of the construction members) of the construction members described above obtained by using a scanner, etc., are stored. The measurement database 22 stores a measurement table 220 in which, at least, as illustrated in Fig 3, with respect to each construction member, a point cloud ID, a member ID, and point coordinates are associated with each other.

In the construction database 6, construction data obtained from a construction plan document and two-dimensional construction drawings to be used for construction of the construction object are stored. The construction database 6 includes at least a construction table 610 storing identification information of construction items, a construction member table 611 for managing members related to the construction, and a construction content table 612 for managing construction content.

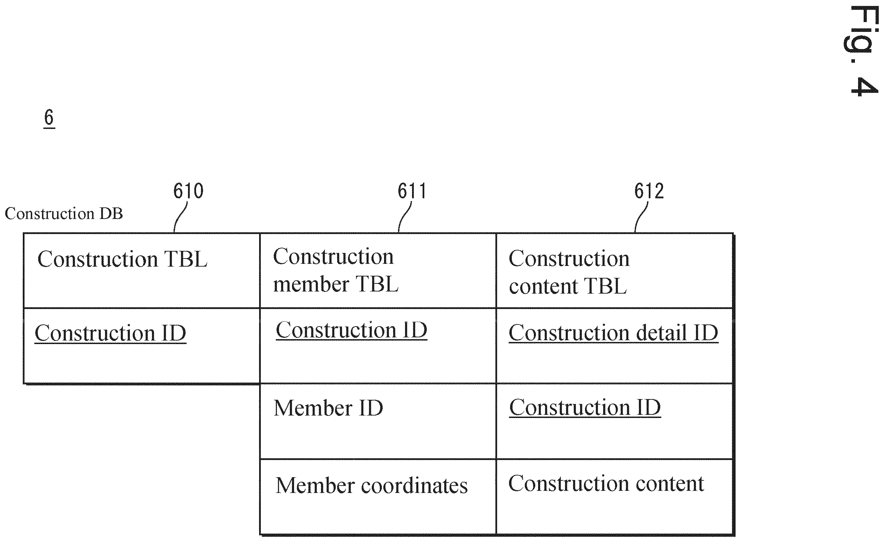

Preferably, as illustrated in Fig. 4, in the construction table 610, identification information (hereinafter, referred to as construction IDs) of the construction items are stored. The construction IDs are, for example, "Iron frame construction," "Door construction," and "Sprinkler construction," etc. In the construction member table 611, construction IDs, member IDs linked to the design database 21 and the measurement database 22, and member coordinates read from two-dimensional construction drawings such as a plan view and an internal finishing table are stored in association with each other. In the construction content table 612, construction IDs, construction detail IDs, and detailed construction content are stored in association with each other. The construction detail IDs are subdivisions of construction content with respect to construction IDs, and are, for example, with respect to "Door construction," check points such as "Check door open/closed" and "Check correction of member peripheral to door" during and after the construction. Construction content is construction conditions and inspection content obtained from a construction plan document and two-dimensional construction drawings, and is, for example, "3/10000 of a floor slope acceptable error reference point with respect to door," etc.

The construction database 6 may be manually created, or may be created by data analysis by a construction DB creating unit 5. The construction DB creating unit 5 is also configured in the same manner as other functional units, and can transmit and receive information. By scanning two-dimensional construction plan documents and construction drawings, the construction DB creating unit 5 retrieves construction items (construction IDs), members necessary for each construction item, member coordinates of each member, and information on construction conditions and inspection content, and stores these in corresponding portions in the construction table 610, the construction member table 611, and the construction content table 612.

In the corrected construction plan database 12, information on a construction designated member for which a construction plan has been corrected is stored as needed by referring to the construction database 6 and a "design corrected model" described later. The corrected construction plan database 12 includes at least a construction plan table 120 storing identification information of construction plans, a construction designated member table 121 for managing construction designated members for which construction plans have been corrected, and a construction inspection content table 123 for managing construction inspection content related to the construction designated members.

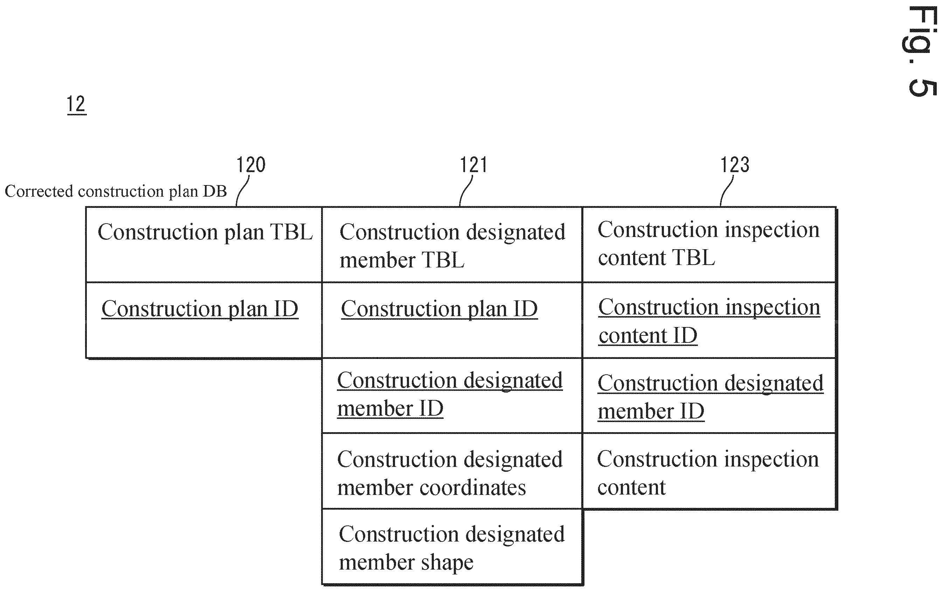

Preferably, as illustrated in Fig. 5, in the construction plan table 120, construction plan IDs are stored. In the construction designated member table 121, construction plan IDs, construction designated member IDs corresponding to member IDs of the construction designated members, construction designated member coordinates, and construction designated member shapes are stored in association with each other. In the construction inspection content table 123, construction inspection content IDs corresponding to construction detail IDs of the construction designated members, construction designated member IDs, and construction inspection content corresponding to the construction content are stored in association with each other. The corrected construction plan database 12 is created by the corrected construction plan creating unit 11. Details of this will be described later.

The construction member selecting unit 7, the peripheral member selecting unit 8, the model creating unit 9, the corrected model creating unit 10, and the corrected construction plan creating unit 11 will be described in a management method according to the present embodiment to be described below.

### (Management Method According to First Embodiment)

In a management method according to the present embodiment, by assuming a case where design BIM (design data) is provided for each member of construction management object, data management for creating a design corrected model, a corrected construction plan document, and a corrected construction drawing, is performed.

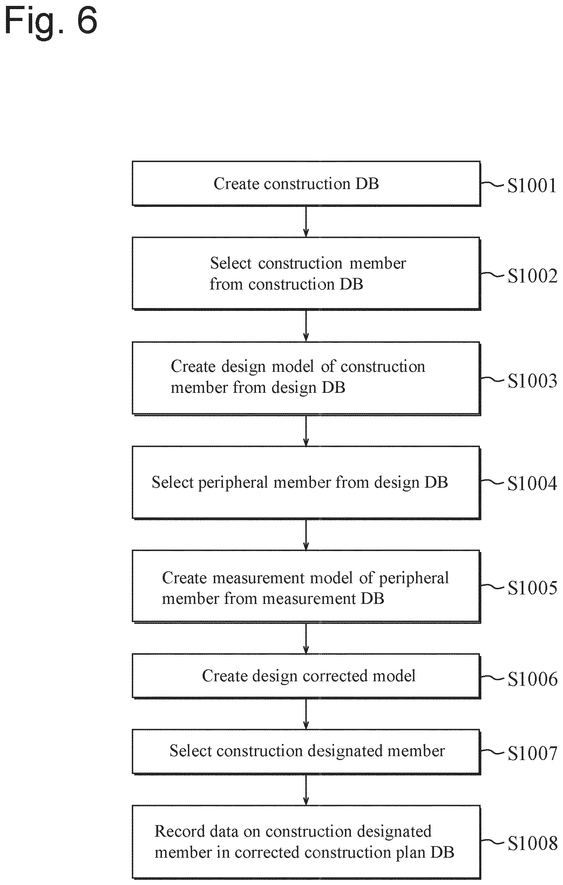

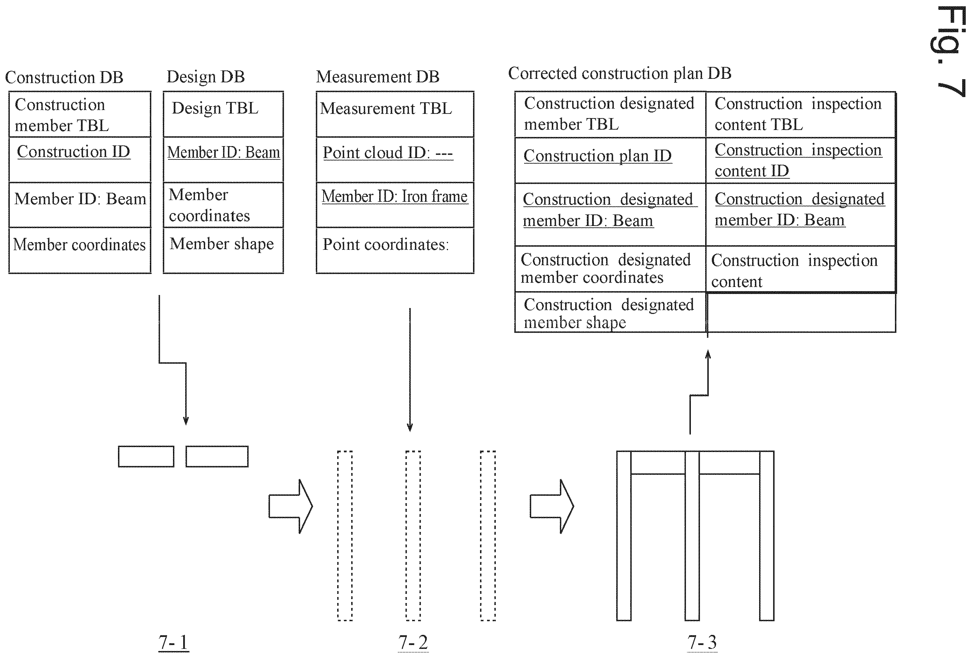

Fig. 6 is a management flowchart illustrating a management method according to the first embodiment of the present invention, and Fig. 7 is a work image view of the management flow.

When management processing is started, in Step S1001, the construction DB creating unit 5 creates a construction database 6. It is also possible that Step S1001 is performed in advance, and management processing is started from the next Step S1002. Step S1002 and subsequent steps are a main part of this management method.

When Step S1002 is started, the construction member selecting unit 7 reads the construction database 6, and displays member IDs on the input/output device 2 and causes an administrator to select a "construction member" as a construction management object. The administrator selects a construction member through the input/output device 2.

Next, the processing shifts to Step S1003, and the model creating unit 9 reads design data linked to the construction member by the member ID from the design database 21, and creates a design model of the construction member.

Next, the processing shifts to Step S1004, and the peripheral member selecting unit 8 reads the design table 210, and extracts a "peripheral member" peripheral to the construction member based on data on coordinates and a shape of the construction member, or displays design models peripheral to the construction member on the input/output device 2 and causes the administrator to select a "peripheral member" peripheral to the construction member.

Next, the processing shifts to Step S1005, and the model creating unit 9 reads measurement data (point cloud data) linked to the peripheral member by the member ID from the measurement database 22, and creates a measurement model of the peripheral member based on the measurement data.

Next, the processing shifts to Step S1006, and the corrected model creating unit 10 creates a "design corrected model" by synthesizing the design model of the construction member created in Step S1003 and the measurement model of the peripheral member created in Step S1005. The design corrected model is created, for example, by correcting, in accordance with a shape (shape in an actual status) of the measurement model, the shape and/or coordinates of the design model so as not to cause interference or correcting the shape and/or coordinates of the design model based on construction error information of the measurement data.

Next, the processing shifts to Step S1007, and the corrected construction plan creating unit 11 causes the administrator to select a member for which a construction plan is desired to be corrected ("construction designated member") based on the design corrected model through the input/output device 2. As the construction designated member, any one of the construction member and peripheral members may be selected.

After the administrator selects a construction designated member, the processing shifts to Step S1008, and the corrected construction plan creating unit 11 provides a construction designated member ID and a construction plan ID to the construction designated member, and with respect to the construction designated member, set coordinates and a shape of the design corrected model as construction designated member coordinates and a construction designated member shape. Further, by referring to the construction content table 612 in the construction database 6, the corrected construction plan creating unit 11 sets construction content linked by a construction ID of the construction designated member as construction inspection content. According to a selection made by the administrator, the construction designated member coordinates, construction designated member shape, and construction inspection content of the construction designated member are recorded in the corrected construction plan database 12. After recording, this management flow is ended.

In Step S1006, the "design corrected model" may be created by synthesizing the design model, the measurement model, and construction data of the construction member and the peripheral member. In this case, in Step S1008, the corrected construction plan creating unit 11 provides a construction designated member ID and a construction plan ID to the construction designated member, and with respect to the construction designated member, sets coordinates and a shape of the design corrected model as construction designated member coordinates and a construction designated member shape, and sets construction content of the construction designated member as construction inspection content.

Concerning construction data, it is also preferable that processing is performed in which, as construction data to be stored in the corrected construction plan database 12, the administrator arbitrarily selects construction data that the administrator desires to add from the construction database 6 and adds the construction data.

A detailed example will be described with reference to Fig. 7. First, in Step S1002, when a "Beam" is selected as a construction member, a design model of the beam is created in S1003 (reference sign 7-1). Next, in Step S1004, an "Iron frame" that comes into contact with an end portion of the "Beam" is selected as a peripheral member, and in Step S1005, a measurement model of the "Iron frame" is created (reference sign 7-2). Next, in Step S1006, a design corrected model is created by synthesizing the design model of the "Beam" and the measurement model of the "Iron frame" (reference sign 7-3). Next, when the "Beam" is selected as a construction designated member in Step S1007, in Step S1008, construction designated member coordinates, a construction designated member shape, and construction inspection content of the "Beam" based on the design corrected model are recorded in the corrected construction database 12 according to a selection made by the administrator.

As described above, according to the management method and the management system of the present embodiment, in a case where design BIM is provided for each member of construction management object, a design corrected model in which an actual construction status has been reflected is created, and data on design corrected coordinates and shape of the construction designated member are managed together with the construction content. Therefore, a corrected construction plan document and a corrected construction drawing of the construction designated member can be created anytime, and can be turned over to the next construction process (downstream process).

### <Second Embodiment>

A management system and a management method according to the present embodiment are additionally applied to the first embodiment. The management system and the management method according to the present embodiment are data management preferable in a case where the construction member and/or the peripheral member is movable (moves). The same configuration and process as in the first embodiment are provided with the same reference signs, and descriptions thereof are omitted.

### (Configuration of Management System According to Second Embodiment)

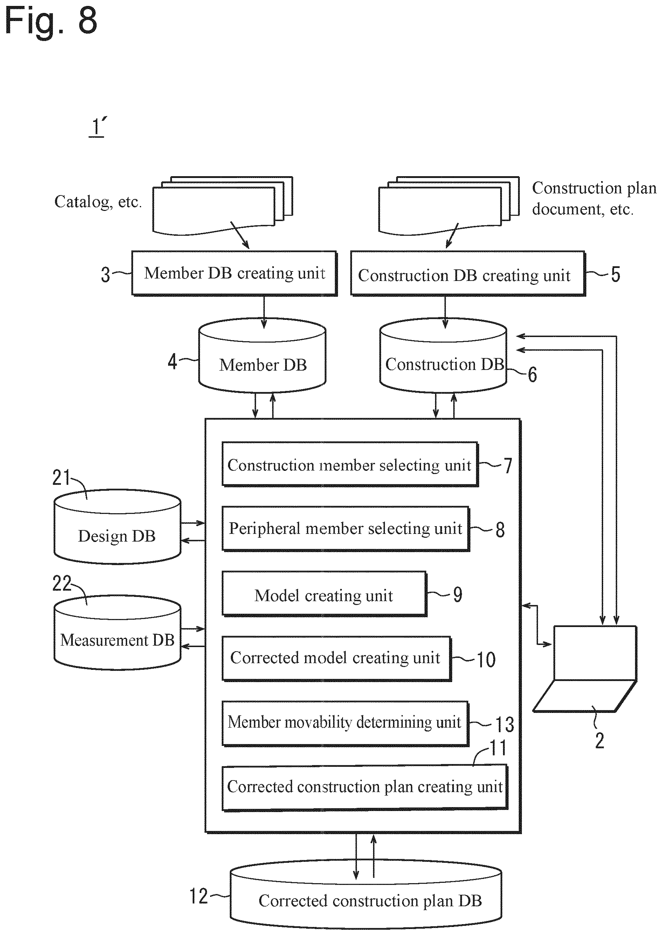

Fig. 8 is a configuration block diagram of a management system 1' according to a second embodiment of the present invention. The management system 1' is configured by adding a member database 4 to the first embodiment. The management system 1' preferably includes a member DB creating unit 3 and a member movability determining unit 13.

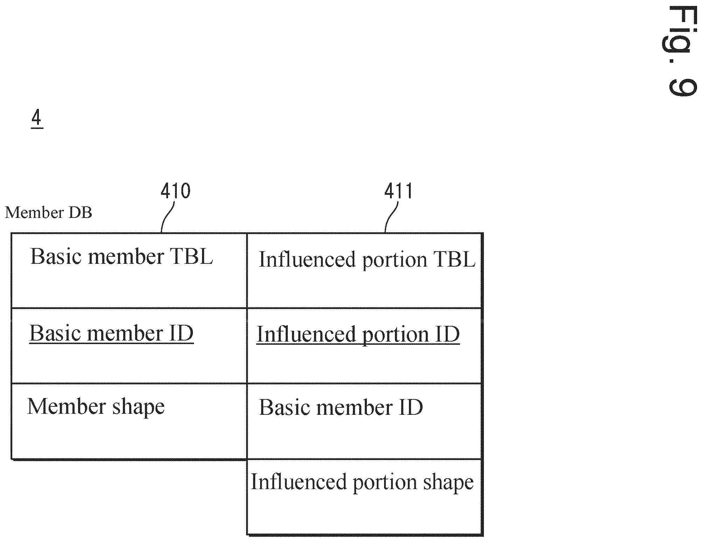

In the member database 4, for each construction member, member basic data (data on member specifications described in a member catalog) is recorded. The member database 4 includes at least a basic member table 410 for managing member shapes of basic members, and an influenced portion table 411 for managing members (or portions) to be influenced by the basic members and shapes of the members (hereinafter, referred to as influenced portion information). Preferably, as illustrated in Fig. 9, in the basic member table 410, identification information of each basic member to be used (hereinafter, referred to as basic member ID) and a member shape of the basic member are stored in association with each other. In the influenced portion table 411, a basic member ID, identification information of a portion to be influenced by the basic member (hereinafter, referred to as influenced portion ID), and information on a shape of the influenced portion are stored in association with each other. For example, with respect to a basic member ID "Steel door," an influenced portion ID such as "Door bottom surface portion," and an influenced portion shape such as "Door movable range shape" are stored.

The member database 4 may be manually created, however, preferably created by data analysis by the member DB creating unit 3. The member DB creating unit 3 is also configured in the same manner as other functional units, and can transmit and receive information. The member DB creating unit 3 retrieves information on basic members to be used, member shapes of the basic members, influenced portions to be influenced by the basic members, and shapes of the influenced portions by scanning the catalog, and stores the information in corresponding portions in the basic member table 410 and the influenced portion table 411.

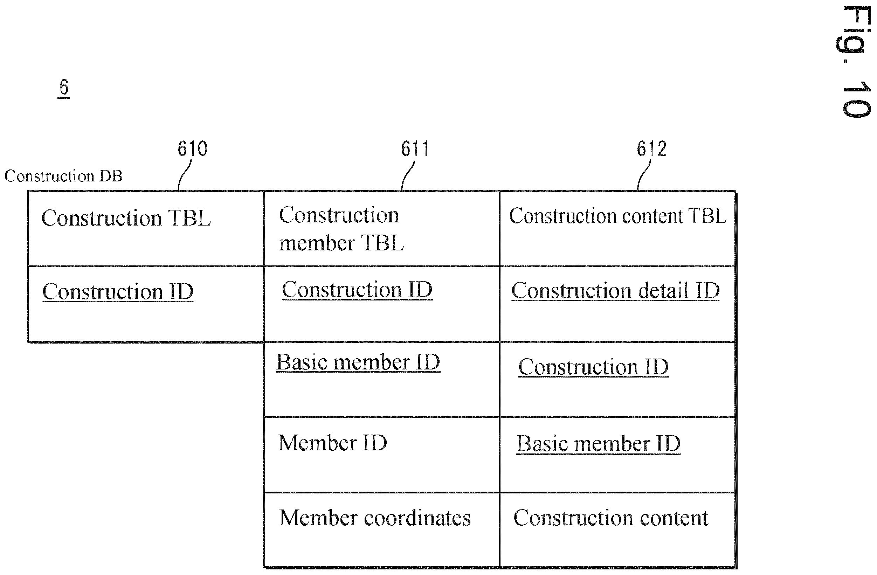

Along with this, as illustrated in Fig. 10, the basic member IDs are also stored in the construction member table 611 and the construction content table 612. The member database 4 is linked to the construction database 6 by the basic member IDs.

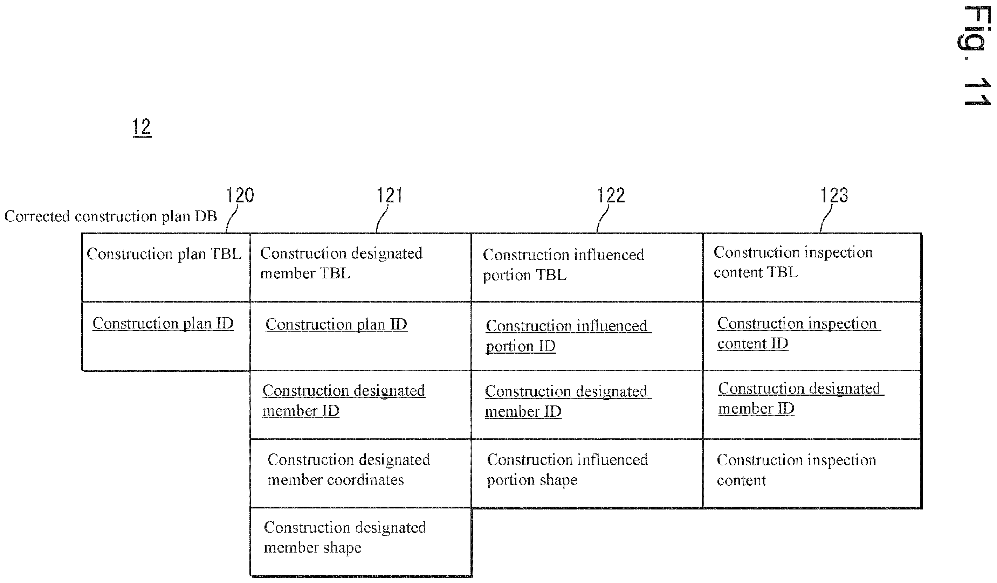

Along with this, as illustrated in Fig. 11, the corrected construction plan database 12 includes a construction influenced portion table 122 for managing an influenced portion of a construction designated member. In the construction influenced portion table 122, a construction influenced portion ID calculated from the basic member table 410, the influenced portion table 411, and the construction member table 611 linked by the basic member ID of the construction designated member, and a construction influenced portion shape corresponding to the influenced portion shape of the construction designated member are stored in association with a construction designated member ID. For example, with respect to a construction designated member "Steel door," information in the basic member table 410, the influenced portion table 411, and the construction member table 611, are acquired, a construction influenced portion ID "Floor" is calculated from coordinates of a bottom surface portion of the door, and a "Door's movable range shape" is acquired as a construction influenced portion shape.

### (Management Method According to Second Embodiment)

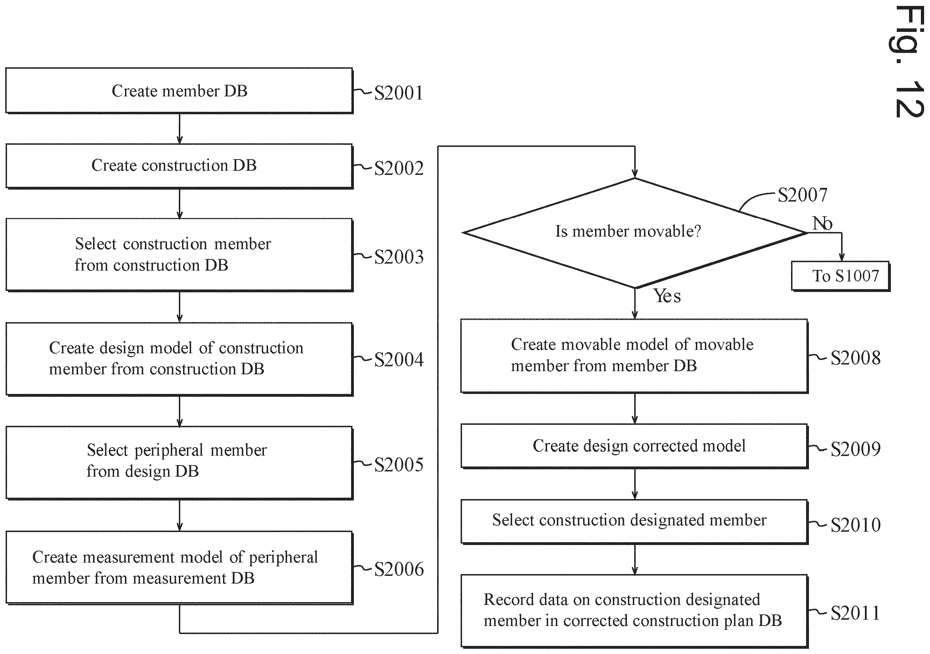

Fig. 12 is a management flowchart illustrating a management method according to the second embodiment of the present invention.

When management processing is started, the member DB creating unit 3 creates the member database 4 in Step S2001, and the construction DB creating unit 5 creates the construction database 6 in Step S2002. It is also possible that Steps S2001 and S2002 are performed in advance, and the management processing is started from the next Step S2003. Step S2003 and subsequent steps are a main part of this management method.

Steps S2003 to S2006 are the same as Steps S1002 to S1005. That is, a construction member is selected based on the construction database 6 in Step S2003, a design model of the construction member is created based on the design database 21 in Step S2004, a peripheral member is selected based on the design database 21 in Step S2005, and a measurement model of the peripheral member is created based on the measurement database 22 in Step S2006.

Next, the processing shifts to Step S2007, and the member movability determining unit 13 or an administrator refers to the member database 4 for the construction member and the peripheral member, and determines whether there is an influenced portion. When an influenced portion ID is found, the member is determined to be "movable" and the processing shifts to Step S2008. When no influenced portion ID is found, the member is determined to be "unmovable," and a design corrected model is created in Step S1007.

On the other hand, when the processing shifts to Step S2008, the member movability determining unit 13 or the administrator refers to the member database 4 for the "movable member" determined to be movable, and inputs an influenced portion shape as movability information of the member into the model creating unit 9. The model creating unit 9 creates a movable model of the movable member (the construction member and/or the peripheral member) based on the movability information. The movable model is created by providing information on a movable range to the design model or the measurement model of the movable member.

Next, the processing shifts to Step S2009, and when the construction member is a movable member, the corrected model creating unit 10 creates a "design corrected model" by synthesizing the measurement model of the peripheral member created in Step S2006 and the movable model of the construction member created in Step S2008. When the peripheral member is a movable member, a "design corrected model" is created by synthesizing the design model of the construction member created in Step S2004 and the movable model of the peripheral member created in Step S2007.

Next, the processing shifts to Step S2010, and the corrected construction plan creating unit 11 causes the administrator to select a member for which a construction plan is desired to be corrected ("correction designated member") based on the design corrected model through the input/output device 2 in the same manner as in Step S1007.

Next, the processing shifts to Step S2011, and in the same manner as in Step S1008, the corrected construction plan creating unit 11 provides a construction designated member ID and a construction plan ID to the construction designated member, and with respect to the construction designated member, sets coordinates and a shape of the design corrected model as construction designated member coordinates and a construction designated member shape. Further, the corrected construction plan creating unit 11 sets construction content related to the construction designated member as construction inspection content by referring to construction database 6, and sets influenced portion information related to the construction designated member as construction influenced portion information by referring to the member database 4, and according to a selection made by the administrator, records the construction designated member coordinates, the construction designated member shape, the construction inspection content, and the construction influenced portion information in the corrected construction plan database 12. After recording, this management flow is ended.

As described above, according to the management method and the management system of the present embodiment, in a case where the construction designated member is movable, data on a member or portion to be influenced by the movement is also managed, so that a corrected construction plan document and a corrected construction drawing including influences from the movement can be created anytime, and can be turned over to the next construction process (downstream process).

### <Third Embodiment>

In a management system and a management method according to the present embodiment, by assuming a case where a or some member of a construction management object is not managed by design BIM (but included in a construction drawing), data management for creating a design corrected model, a corrected construction plan document, and a corrected construction drawing is performed. The same configuration and process as in the embodiments described above are provided with the same reference signs, and descriptions thereof are omitted.

### (Configuration of Management System According to Third Embodiment)

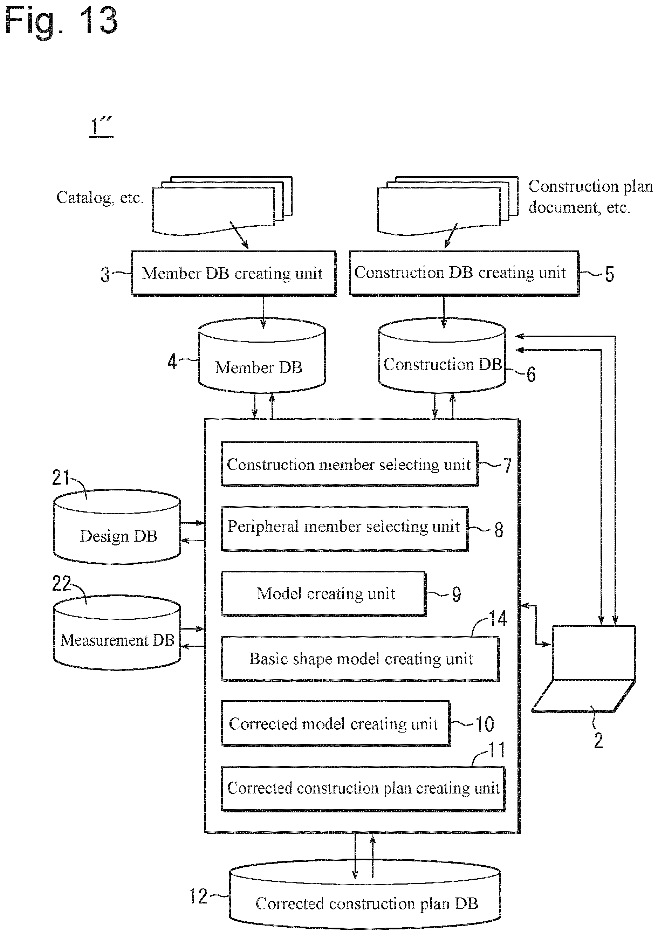

Fig. 13 is a configuration block diagram of a management system 1" according to a third embodiment of the present invention. The management system 1" includes the input/output device 2, the member database 4, the construction database 6, the construction member selecting unit 7, the peripheral member selecting unit 8, the model creating unit 9, a basic shape model creating unit 14, the corrected model creating unit 10, the corrected construction plan creating unit 11, and the corrected construction plan database 12, and uses, as data serving as materials, the design database 21 and the measurement database 22. The member database 4 is preferably created by the member DB creating unit 3, the construction database 6 is preferably created by the construction DB creating unit 5, and the corrected construction plan database 12 is created by the corrected construction plan creating unit 11.

The construction member selecting unit 7, the peripheral member selecting unit 8, the model creating unit 9, the basic shape model creating unit 14, the corrected model creating unit 10, and the corrected construction plan creating unit 11 in the present embodiment will be described in a management method according to the present embodiment to be described below.

### (Management Method According to Third Embodiment)

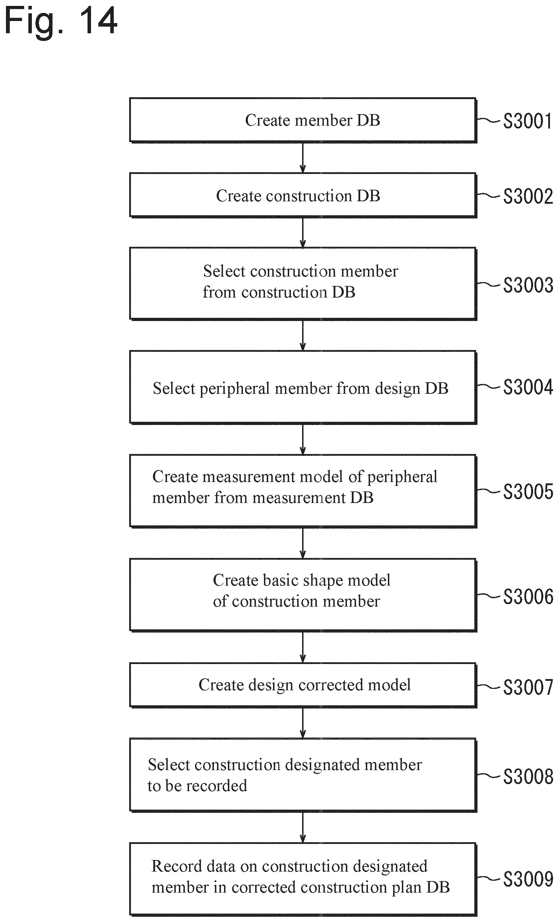

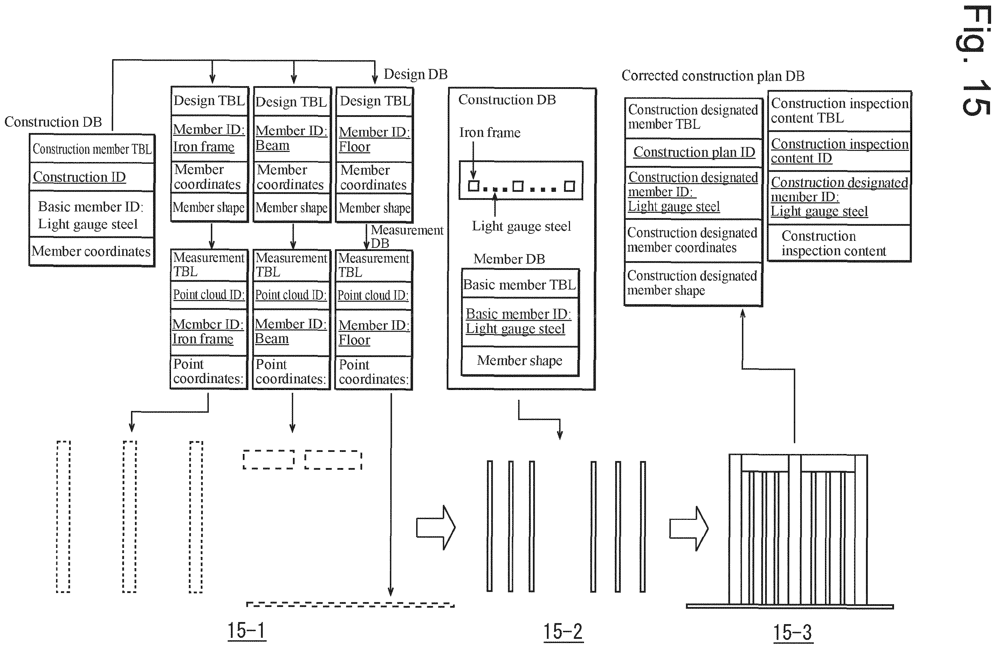

Fig. 14 is a management flowchart illustrating a management method according to the third embodiment of the present invention, and Fig. 15 is a work image view of the management flow.

When management processing is started, the member DB creating unit 3 creates the member database 4 in Step S3001, and the construction DB creating unit 5 creates the construction database 6 in Step S3002. It is also possible that Steps S3001 and S3002 are performed in advance, and the management processing is started from the next Step S3003. Step S3003 and subsequent steps are a main part of this management method.

When the processing shifts to Step S3003, the construction member selecting unit 7 reads the construction member table 611 (Fig. 10) in the construction database 6 and causes an administrator to select a "construction member" of a construction management object.

Next, the processing shifts to Step S3004, and the peripheral member selecting unit 8 reads the design table 210 in the design database 21, and extracts a "peripheral member" peripheral to the construction member based on member coordinates (coordinates of an end portion, etc.,) of the construction member referred to from the construction member table 611, or displays design models peripheral to the construction member on the input/output device 2 and causes the administrator to select a "peripheral member" peripheral to the construction member.

Next, the processing shifts to Step S3005, and with respect to the peripheral member, the model creating unit 9 reads measurement data (point cloud data) linked by the member ID from the measurement database 22 (Fig. 3), and creates a measurement model of the construction member based on the measurement data.

Next, the processing shifts to Step S3006, and with respect to the construction member, the basic shape model creating unit 14 reads member basic data (member shape) of the construction member from the member database 4 (Fig. 9) and construction data (member coordinates) in the construction database 6 based on the basic member ID, and creates a basic shape model of the construction member based on the member basic data and the construction data.

Next, the processing shifts to Step S3007, and the corrected model creating unit 10 creates a "design corrected model" by synthesizing the measurement model of the peripheral member created in Step S3005 with the basic shape model of the construction member created in Step S3006. The design corrected model is created, for example, by correcting, in accordance with a shape of the measurement model (shape in an actual status), a shape and/or coordinates of the basic shape model so as not to cause interference or correcting a shape and/or coordinates of the basic shape model based on construction error information.

Next, the processing shifts to Step S3008, and the corrected construction plan creating unit 11 causes the administrator to select a member for which a construction plan is desired to be corrected ("construction designated member") based on the design corrected model through the input/output device 2 in the same manner as in Step S1007. As the construction designated member, any one of the construction member and peripheral members may be selected.

Next, the processing shifts to Step S3009, and with respect to the construction designated member, the corrected construction plan creating unit 11 sets coordinates and a shape of the design corrected model as construction designated member coordinates and a construction designated member shape as in Step S1008. Further, the corrected construction plan creating unit 11 sets construction content related to the construction designated member as construction inspection content by referring to the construction database 6. Then, according to a selection made by the administrator, the construction designated member coordinates, the construction designated member shape, and the construction inspection content of the construction designated member are recorded in the corrected construction plan database 12. After recording, this management flow is ended.

It is also preferable that, in Step S3007, the "design corrected model" is created by synthesizing the measurement model, the basic shape model, and construction data of the construction member and the peripheral member.

Concerning creation and recording of the basic shape model, it is also preferable that according to a request of the administrator, processing is performed in which only the basic shape model of the construction member is created, and the construction member is directly recorded as a construction designated member in the corrected construction plan database 12. That is, a management system and a management method only configured by Step S3003 to be performed by the construction member selecting unit 7, Step S3006 to be performed by the basic shape model creating unit 14, and Step S3009 to be performed by the corrected construction plan creating unit 11 are also preferable.

Concerning construction data, it is also preferable that processing is performed in which, as construction data to be stored in the corrected construction plan database 12, construction data desired to be added is directly selected from the construction database 6 and added by the administrator.

A detailed example will be described with reference to Fig. 15. First, when a "Light gauge steel" is selected as a construction member through Step S3003, a "Beam," a "Floor," and an "Iron frame" peripheral to the "Light gauge steel" are selected as peripheral members in Step S3004. Next, measurement models of the "Beam," the "Floor," and the "Iron frame" as peripheral members are created in Step S3005 (reference sign 15-1), and a basic shape model of the "Light gauge steel" as the construction member is created in Step S3006 (reference sign 15-2). Next, a design corrected model is created by synthesizing the measurement models of the "Beam," "Floor," and "Iron frame" with the basic shape model of the "Light gauge steel" in Step S3007 (reference sign 15-3). Next, when the "Light gauge steel" is selected as a construction designated member in Step S3008, construction designated member coordinates, a construction designated member shape, and construction inspection content of the "Light gauge steel" based on the design corrected model are recorded in the corrected construction database 12 in Step S3009 according to a selection made by the administrator.

As described above, according to the management method and the management system of the present embodiment, in the case where a member of a construction management object is not managed by design BIM, the data on this member (construction member) is complemented by setting as a construction designated member, and design correction data (coordinates, shape) is recorded together with construction content in the corrected construction plan database 12. Therefore, with respect to a member not managed by design BIM, a design corrected model, a corrected construction plan document, and a corrected construction drawing can be created anytime, and can be turned over to the next construction process (downstream process).

### <Fourth Embodiment>

A management system and a management method according to the present embodiment are additionally applied to the third embodiment. The management system and the management method according to the present embodiment are data management preferable in a case where the construction member or the peripheral member is movable (moves). The same configuration and process as in the third embodiment are provided with the same reference signs, and descriptions thereof are omitted.

### (Configuration of Management System According to Fourth Embodiment)

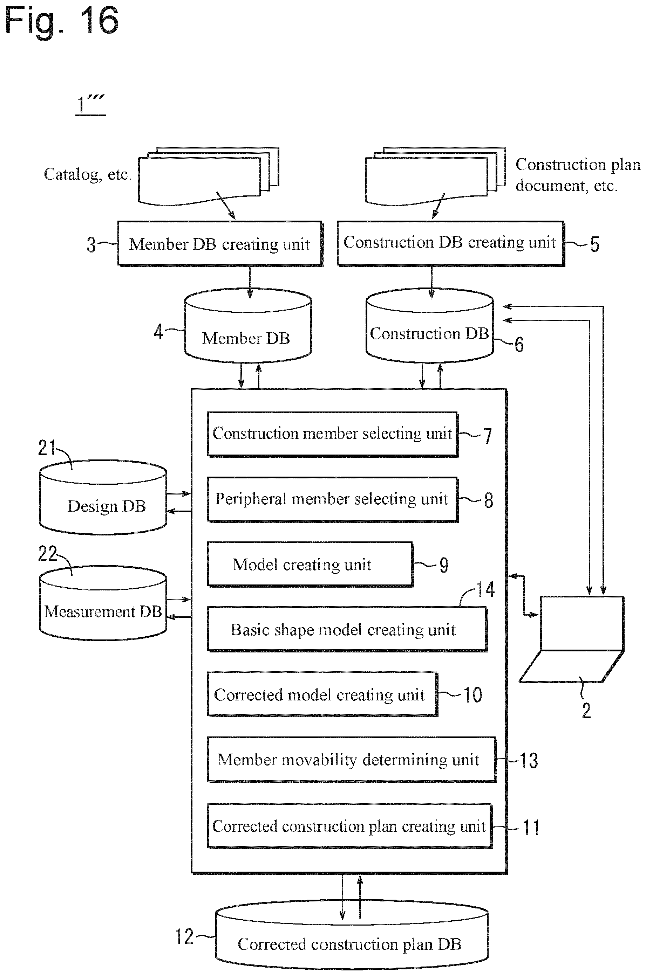

Fig. 16 is a configuration block diagram of a management system 1‴ according to a fourth embodiment of the present invention. The management system 1‴ preferably includes the member movability determining unit 13 in the third embodiment.

### (Management Method According to Fourth Embodiment)

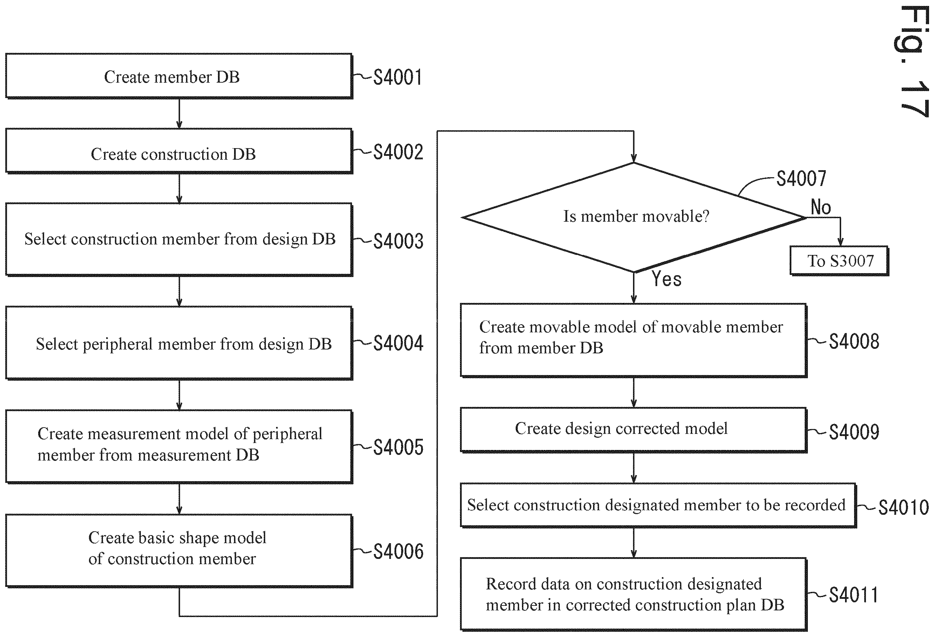

Fig. 17 is a management flowchart illustrating a management method according to the fourth embodiment of the present invention.

When management processing is started, the member DB creating unit 3 creates the member database 4 in Step S4001, and the construction DB creating unit 5 creates the construction database 6 in Step S4002. It is also possible that these steps are performed in advance, and the processing is started from Step S4003. Step S4003 and subsequent steps are a main part of this management method.

Steps S4003 to S4006 are the same as Steps S3003 to S3006. That is, a construction member is selected in Step S4003, a peripheral member is selected in Step S4004, a measurement model of the peripheral member is created in Step S4005, and a basic shape model of the construction member is created in Step S4006.

Next, the processing shifts to Step S4007, and the member movability determining unit 13 or the administrator refers to the member database 4 for the construction member and the peripheral member and determines whether there is an influenced portion. When an influenced portion ID is found, the member is determined to be "movable" and the processing shifts to Step S4008. When no influenced portion ID is found, the member is determined to be "unmovable," and a design corrected model is created in Step S3007.

On the other hand, when the processing shifts to Step S4008, the member movability determining unit 13 or the administrator refers to the member database 4 for the "movable member" determined to be movable, and inputs an influenced portion shape as movability information of the member into the model creating unit 9. The model creating unit 9 creates a movable model of the movable member (construction member and/or peripheral member) based on the movability information. The movable model is created by providing information on a movable range to the measurement model or the basic shape model of the movable member.

Next, the processing shifts to Step S4009, and when the construction member is a movable member, the corrected model creating unit 10 creates a "design corrected model" by synthesizing the movable model of the construction member created in Step S4008 and the measurement model of the peripheral member created in Step S4006. When the peripheral member is a movable member, a "design corrected model" is created by synthesizing the basic shape model of the construction member created in Step S4006 and the movable model of the peripheral member created in Step S4008.

Next, the processing shifts to Step S4010, and the corrected construction plan creating unit 11 causes the administrator to select a member for which a construction plan is desired to be corrected ("construction designated member") based on the design corrected model through the input/output device 2 in the same manner as in Step S3008.

Next, the processing shifts to Step S4011, and as in Step S3009, the corrected construction plan creating unit 11 provides a construction designated member ID and a construction plan ID to the construction designated member, and with respect to the construction designated member, sets coordinates and a shape of the design corrected model as construction designated member coordinates and a construction designated member shape. Further, the corrected construction plan creating unit 11 sets construction content related to the construction designated member as construction inspection content by referring to the construction database 6, sets influenced portion information related to the construction designated member as construction influenced portion information by referring to the member database 4, and according to a selection made by the administrator, records the construction designated member coordinates, the construction designated member shape, the construction inspection content, and the construction influenced portion information in the corrected construction plan database 12. After recording, this management flow is ended.

As described above, according to the management method and the management system of the present embodiment, in a case where the construction designated member is movable, data on a member or portion to be influenced by the movement is also managed, so that a corrected construction plan document and a corrected construction drawing including influences from the movement can be created anytime, and can be turned over to the next construction process (downstream process).

### <Fifth Embodiment>

In a management system and a management method according to the present embodiment, by utilizing data managed in the corrected construction plan database 12, data management to reflect the correction in design BIM (upstream) is performed. The present embodiment is management when a correction reflection member is included in design BIM (design data).

### (Configuration of Management System According to Fifth Embodiment)

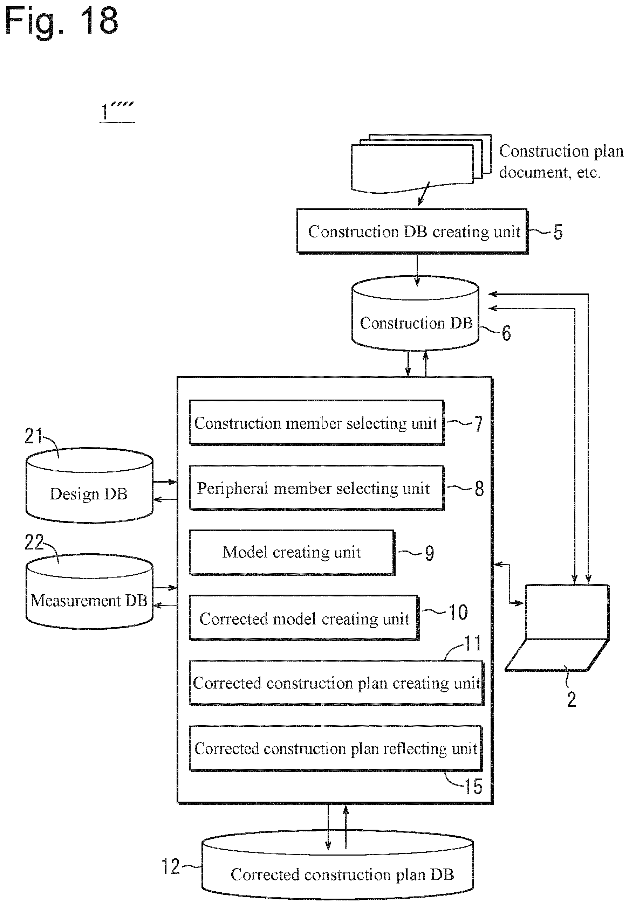

Fig. 18 is a configuration block diagram of a management system 1ʺʺ according to a fifth embodiment of the present invention. The management system 1ʺʺ of the present embodiment is configured by adding a corrected construction plan reflecting unit 15 to the first embodiment. The corrected construction plan reflecting unit 15 is also configured in the same manner as other functional units, and can transmit and receive information.

### (Management Method According to Fifth Embodiment)

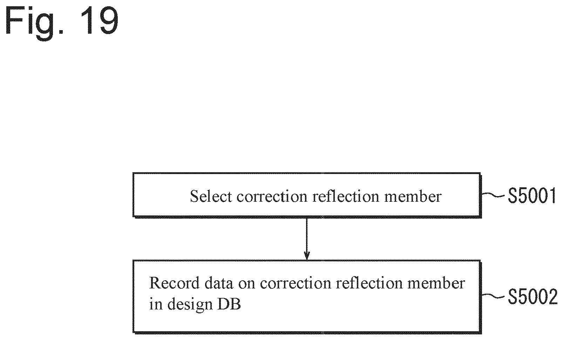

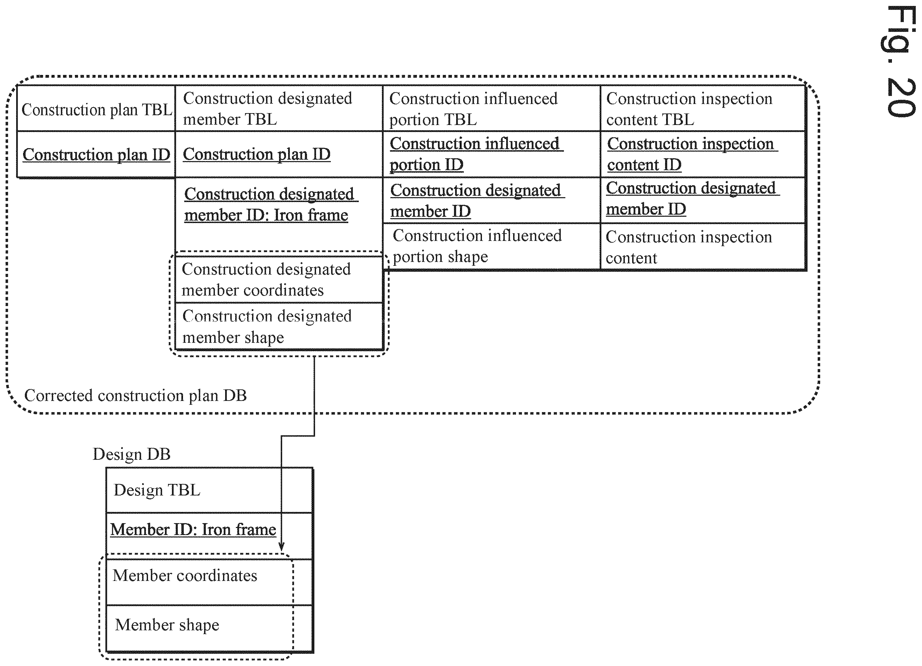

Fig. 19 is a management flowchart illustrating a management method according to the fifth embodiment of the present invention, and Fig. 20 is a work image view of the management flow. Upon starting of management processing according to the present embodiment, the processing shifts to Step S5001, and the corrected construction plan reflecting unit 15 reads the corrected construction plan database 12 and causes an administrator to select a "correction reflection member" the correction of which is desired to be reflected in design BIM based on a construction designated member ID.

Next, the processing shifts to Step S5002, and the corrected construction plan reflecting unit 15 writes data on construction designated member coordinates and a construction designated member shape of the correction reflection member over member coordinates and a member shape linked by the member ID of the correction reflection member in the design database 21 (refer to Fig. 20). After updating the design database 21, the corrected construction plan reflecting unit 15 ends this management flow.

### <Sixth Embodiment>

In a management system and a management method according to the present embodiment, by utilizing data managed in the corrected construction plan database 12, data management to reflect correction in design BIM (upstream) is performed. The present embodiment is management when a correction reflection member is not included in design BIM (design data).

### (Configuration of Management System According to Sixth Embodiment)

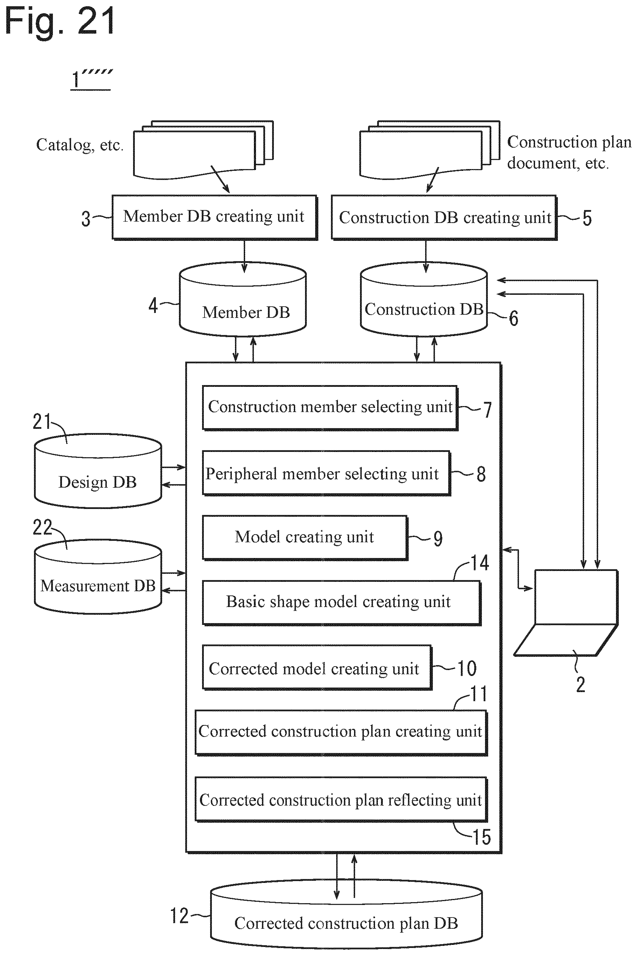

Fig. 21 is a configuration block diagram of a management system 1‴ʺ according to a sixth embodiment of the present invention. The management system 1‴ʺ of the present embodiment is configured by adding the corrected construction plan reflecting unit 15 to the third embodiment.

### (Management Method According to Sixth Embodiment)

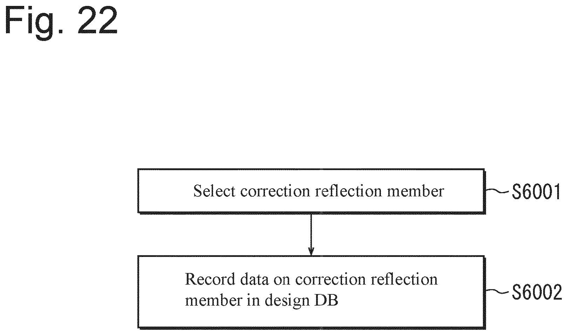

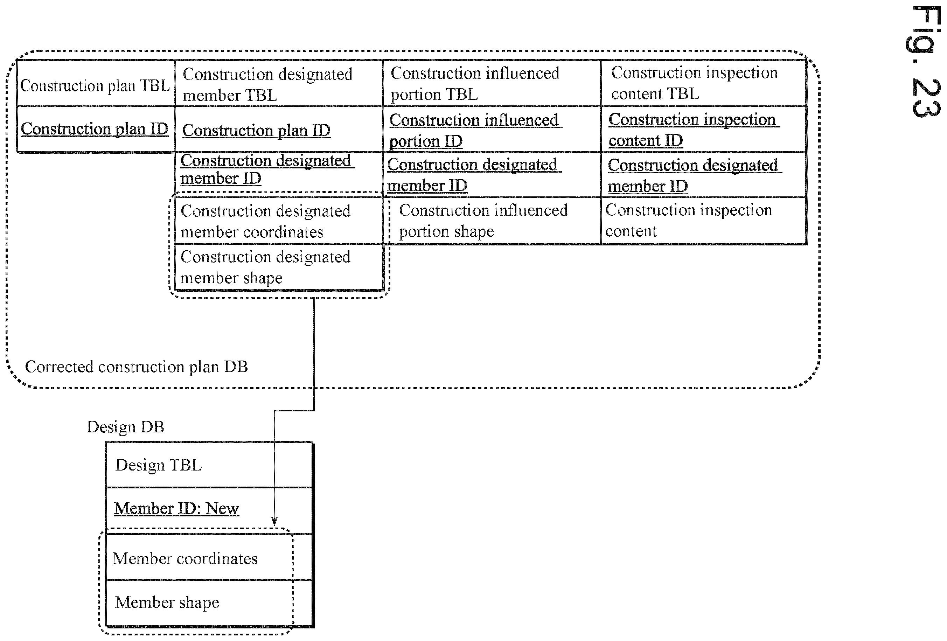

Fig. 22 is a management flowchart illustrating a management method according to the sixth embodiment of the present invention, and Fig. 23 is a work image view of the management flow. Upon starting of management processing according to the present embodiment, the processing shifts to Step S6001, and the corrected construction plan reflecting unit 15 reads the corrected construction plan database 12 and causes an administrator to select a "correction reflection member" based on a construction designated member ID.

Next, the processing shifts to Step S6002, and the corrected construction plan reflecting unit 15 provides a new member ID to data on construction designated member coordinates and a construction designated member shape of the selected correction reflection member, and adds the data into the design database 21 (refer to Fig. 23). After updating the design database 21, the corrected construction plan reflecting unit 15 ends this management flow.

As described above, according to the management methods and the management systems of the fifth and sixth embodiments, design correction data of a member managed in the corrected construction plan database 12 in which an actual construction status has been reflected can be reflected in or added to design BIM (upstream process). Therefore, at a construction site, a situation where information of design BIM to be referred to each time of the progression of processes is used while being left old in a downstream process, and an actual on-site status and the construction drawing do not match, can be prevented, and it becomes possible to efficiently utilize BIM at the construction site. The corrected construction plan reflecting unit 15 in the present embodiment is also applicable to the second and fourth embodiments.

The data recorded in the corrected construction plan database 12 in the first to sixth embodiments can be output from the corrected construction plan database 12 to an external system, and the design correction data can be used and utilized in the external system.

Preferred embodiments and modifications of the present invention have been described above, and each embodiment and each modification can be combined based on the knowledge of a person skilled in the art. The claims define the scope of the present invention.

### Reference Signs List

- 1, 1', 1", 1‴, 1ʺʺ, 1‴ʺ: Management system
- 2: Input/output device
- 4: Member database
- 410: Basic member table
- 411: Influenced portion table
- 6: Construction database
- 610: Construction table
- 611: Construction member table
- 612: Construction content table
- 7: Construction member selecting unit
- 8: Peripheral member extracting unit
- 9: Model creating unit
- 10: Corrected model creating unit
- 11: Corrected construction plan creating unit
- 12: Corrected construction plan database
- 120: Construction plan table
- 121: Construction designated member table
- 122: Construction influenced portion table
- 123: Construction inspection content table
- 13: Member movability determining unit
- 14: Basic shape model creating unit
- 15: Corrected construction plan reflecting unit
- 21: Design database
- 22: Measurement database

## Claims

1. A management method wherein, by transmitting and receiving information to and from databases, where the databases includes:
a design database (21) recording design data of construction members constituting a construction object, a measurement database (22) recording measurement data of the construction members, and a construction database (6) storing construction data of the construction members, the following steps (A) to (G) are implemented:
a step (A) of selecting a construction member from the construction database;
a step (B) of creating a design model of the construction member from design data of the construction member in the design database;
a step (C) of selecting a peripheral member peripheral to the construction member from the design database;
a step (D) of creating a measurement model of the peripheral member from measurement data of the peripheral member in the measurement database;
a step (E) of creating a design corrected model by synthesizing the design model and the measurement model and correcting the shape and/or coordinates of the design model, in accordance with a shape of the measurement model;
a step (F) of selecting a construction designated member for which a construction plan is corrected based on the design corrected model;
a step (G) of recording, with respect to the construction designated member, coordinates and a shape of the design corrected model as construction designated member coordinates and a construction designated member shape, and construction content of the construction designated member as construction inspection content, in a corrected construction plan database.

2. The management method according to Claim 1, wherein further,
by transmitting and receiving information to and from a member database recording member basic data of the construction members,
before the step (E), whether the construction member and the peripheral member are movable members is determined by referring to the member database, and when the member is determined to be unmovable, the design corrected model is created in the step (E), and when the member is determined to be movable, movability information of the movable member is read from the member database and a movable model of the movable member is created, and a design corrected model is created by synthesizing the design model or the measurement model with the movable model, and the processing shifts to the step (F), and
in the step (G), by further referring to the member database, construction influenced portion information based on the movability information of the movable member is recorded in the corrected construction plan database.

3. The management method according to Claim 1 or 2, further comprising:
a step of writing the construction designated member coordinates and the construction designated member shape of the construction designated member recorded in the corrected construction plan database over member coordinates and a member shape linked by member identification information of the construction designated member in the design database.

4. The management method according to anyone of claims
1 to 3, further comprising: a step of newly adding the construction designated member, the construction designated member coordinates, and the construction designated member shape recorded in the corrected construction plan database into the design database.

5. The management method according to anyone of claims
1 to 4, wherein, in the step (E), the shape and/or coordinates of the design model is corrected in accordance with a shape of the measurement model so as not to cause interference.

6. The management method according to anyone of claims 1 to 4, wherein, in the step (E), the shape and/or coordinates of the design model is corrected in accordance with a shape of the measurement model based on construction error information of the measurement data.

7. A management program describing the management method according to any one of Claims 1 to 6 as a computer program and enabling execution of the management method.

8. A management system comprising:
a design database (21) recording design data of construction members constituting a construction object;
a measurement database (22) recording measurement data of the construction members;
a construction database (6) storing construction data of the construction members;
a construction member selecting unit (5) configured to select a construction member from the construction database;
a peripheral member selecting unit (8) configured to select a peripheral member peripheral to the construction member from the design database;
a model creating unit (9) configured to create a design model of the construction member from the design data of the construction member, and a measurement model of the peripheral member from the measurement data of the peripheral member;
a corrected model creating unit (12) configured to create a design corrected model by synthesizing the design model and the measurement model and correcting the shape and/or coordinates of the design model, in accordance with a shape of the measurement model; and
a corrected construction plan creating unit (11) configured to select a construction designated member for which a construction plan is corrected based on the design corrected model, and record, with respect to the construction designated member, coordinates and a shape of the design corrected model as construction designated member coordinates and a construction designated member shape, and construction content of the construction designated member as construction inspection content, in a corrected construction plan database (12).

9. The management system according to Claim 8, further comprising:
a member database recording member basic data of the construction members; and
a member movability determining unit configured to determine whether the construction member and the peripheral member are movable members by referring to the member database, and when determining that the member is movable, read movability information of the movable member from the member database and create a movable model of the movable member, wherein
the corrected model creating unit creates a design corrected model by synthesizing the design model or the measurement model with the movable model, and
the corrected construction plan creating unit refers to the member database and further records construction influenced portion information based on the movability information of the movable member in the corrected construction plan database.

10. The management system according to Claim 8 or 9, further comprising:
a corrected construction plan reflecting unit configured to write the construction designated member coordinates and the construction designated member shape of the construction designated member recorded in the corrected construction plan database over member coordinates and a member shape linked by member identification information of the construction designated member in the design database.

11. The management system according to anyone of claims 8 or 9 , further comprising: a corrected construction plan reflecting unit configured to newly add the construction designated member, the construction designated member coordinates, and the construction designated member shape recorded in the corrected construction plan database into the design database.

12. The management system according to anyone of claims 8 to 11, wherein the corrected model creating unit is configured to correct the shape and/or coordinates of the design model in accordance with a shape of the measurement model so as not to cause interference.

13. The management system according to anyone of claims 8 to 11, wherein the corrected model creating unit is configured to correct the shape and/or coordinates of the design model in accordance with a shape of the measurement model based on construction error information of the measurement data.

## Patentansprüche

1. Verwaltungsverfahren, bei dem durch Senden und Empfangen von Informationen zu und von Datenbanken, wobei die Datenbanken Folgendes umfassen: eine Designdatenbank (21), die Designdaten von Bauteilen aufzeichnet, die ein Bauobjekt bilden, eine Messdatenbank (22), die Messdaten der Bauteile aufzeichnet, und eine Baudatenbank (6), die Baudaten der Bauteile speichert, die folgenden Schritte (A) bis (G) durchgeführt werden:
Schritt (A) des Auswählens eines Bauteils aus der Baudatenbank;
Schritt (B) des Erstellens eines Designmodells des Bauteils aus Designdaten des Bauteils in der Designdatenbank;
Schritt (C) des Auswählens eines zum Bauteil peripheren Bauteils aus der Designdatenbank;
Schritt (D) des Erstellens eines Messmodells des peripheren Bauteils aus Messdaten des peripheren Bauteils in der Messdatenbank;
Schritt (E) des Erstellens eines korrigierten Designmodells durch Synthetisieren des Designmodells und des Messmodells und Korrigieren der Form und/oder der Koordinaten des Designmodells entsprechend einer Form des Messmodells;
Schritt (F) des Auswählens eines Ausführungsbauteils, für das ein Bauplan auf der Grundlage des korrigierten Designmodells korrigiert wird;
Schritt (G) des Aufzeichnens, in Bezug auf das Ausführungsbauteil, von Koordinaten und einer Form des korrigierten Designmodells als Koordinaten des Ausführungsbauteils und als Form des Ausführungsbauteils sowie von Bauinhalten des Ausführungsbauteils als Bauprüfinhalt in eine Datenbank für korrigierte Baupläne.

2. Verwaltungsverfahren nach Anspruch 1, wobei ferner,
durch Senden und Empfangen von Informationen zu und von einer Bauteildatenbank, die Bauteilgrunddaten der Bauteile aufzeichnet,
vor dem Schritt (E) durch Bezugnahme auf die Bauteildatenbank bestimmt wird, ob das Bauteil und das periphere Bauteil bewegliche Bauteile sind, und wenn bestimmt wird, dass das Bauteil unbeweglich ist, das korrigierte Designmodell im Schritt (E) erstellt wird, und wenn bestimmt wird, dass das Bauteil beweglich ist, Beweglichkeitsinformationen des beweglichen Bauteils aus der Bauteildatenbank ausgelesen werden und ein Bewegungsmodell des beweglichen Bauteils erstellt wird und ein korrigiertes Designmodell durch Synthetisieren des Designmodells oder des Messmodells mit dem Bewegungsmodell erstellt wird und die Verarbeitung zum Schritt (F) übergeht, und
im Schritt (G) durch weitere Bezugnahme auf die Bauteildatenbank Informationen über baulich beeinflusste Teilbereiche auf der Grundlage der Beweglichkeitsinformationen des beweglichen Bauteils in die Datenbank für korrigierte Baupläne aufgezeichnet werden.

3. Verwaltungsverfahren nach Anspruch 1 oder 2, ferner umfassend:
einen Schritt des Überschreibens von Bauteilkoordinaten und einer Bauteilform, die über Bauteilidentifikationsinformationen des Ausführungsbauteils in der Designdatenbank verknüpft sind, mit den Koordinaten des Ausführungsbauteils und der Form des Ausführungsbauteils, die in der Datenbank für korrigierte Baupläne aufgezeichnet sind.

4. Verwaltungsverfahren nach einem der Ansprüche 1 bis 3, ferner umfassend:
einen Schritt des neuen Hinzufügens des Ausführungsbauteils, der Koordinaten des Ausführungsbauteils und der Form des Ausführungsbauteils, die in der Datenbank für korrigierte Baupläne aufgezeichnet sind, in die Designdatenbank.

5. Verwaltungsverfahren nach einem der Ansprüche 1 bis 4, wobei im Schritt (E) die Form und/oder die Koordinaten des Designmodells entsprechend einer Form des Messmodells so korrigiert werden, dass keine Kollision entsteht.

6. Verwaltungsverfahren nach einem der Ansprüche 1 bis 4, wobei im Schritt (E) die Form und/oder die Koordinaten des Designmodells auf der Grundlage von Baufehlerinformationen der Messdaten entsprechend einer Form des Messmodells korrigiert werden.

7. Verwaltungsprogramm, das das Verwaltungsverfahren nach einem der Ansprüche 1 bis 6 als Computerprogramm beschreibt und die Ausführung des Verwaltungsverfahrens ermöglicht.

8. Verwaltungssystem, umfassend:
eine Designdatenbank (21), die Designdaten von Bauteilen aufzeichnet, die ein Bauobjekt bilden;
eine Messdatenbank (22), die Messdaten der Bauteile aufzeichnet;
eine Baudatenbank (6), die Baudaten der Bauteile speichert;
eine Bauteilauswahleinheit (5), die dazu konfiguriert ist, ein Bauteil aus der Baudatenbank auszuwählen;
eine Peripherbauteilauswahleinheit (8), die dazu konfiguriert ist, ein zum Bauteil peripheres Bauteil aus der Designdatenbank auszuwählen;
eine Modellerstellungseinheit (9), die dazu konfiguriert ist, ein Designmodell des Bauteils aus den Designdaten des Bauteils und ein Messmodell des peripheren Bauteils aus den Messdaten des peripheren Bauteils zu erstellen;
eine Erstellungseinheit eines korrigierten Modells (12), die dazu konfiguriert ist, ein korrigiertes Designmodell durch Synthetisieren des Designmodells und des Messmodells und Korrigieren der Form und/oder der Koordinaten des Designmodells entsprechend einer Form des Messmodells zu erstellen; und
eine Erstellungseinheit eines korrigierten Bauplans (11), die dazu konfiguriert ist, ein Ausführungsbauteil auszuwählen, für das ein Bauplan auf der Grundlage des korrigierten Designmodells korrigiert wird, und, in Bezug auf das Ausführungsbauteil, Koordinaten und eine Form des korrigierten Designmodells als Koordinaten des Ausführungsbauteils und als Form des Ausführungsbauteils sowie Bauinhalte des Ausführungsbauteils als Bauprüfinhalt in eine Datenbank für korrigierte Baupläne (12) aufzuzeichnen.

9. Verwaltungssystem nach Anspruch 8, ferner umfassend:
eine Bauteildatenbank, die Bauteilgrunddaten der Bauteile aufzeichnet; und
eine Bauteilbeweglichkeitsbestimmungseinheit, die dazu konfiguriert ist, durch Bezugnahme auf die Bauteildatenbank zu bestimmen, ob das Bauteil und das periphere Bauteil bewegliche Bauteile sind, und, wenn bestimmt wird, dass das Bauteil beweglich ist, Beweglichkeitsinformationen des beweglichen Bauteils aus der Bauteildatenbank auszulesen und ein Bewegungsmodell des beweglichen Bauteils zu erstellen, wobei
die Erstellungseinheit des korrigierten Modells durch Synthetisieren des Designmodells oder des Messmodells mit dem Bewegungsmodell ein korrigiertes Designmodell erstellt und
die Erstellungseinheit des korrigierten Bauplans auf die Bauteildatenbank Bezug nimmt und ferner Informationen über baulich beeinflusste Teilbereiche auf der Grundlage der Beweglichkeitsinformationen des beweglichen Bauteils in die Datenbank für korrigierte Baupläne aufzeichnet.

10. Verwaltungssystem nach Anspruch 8 oder 9, ferner umfassend:
eine Übertragungseinheit des korrigierten Bauplans, die dazu konfiguriert ist, Bauteilkoordinaten und eine Bauteilform, die über Bauteilidentifikationsinformationen des Ausführungsbauteils in der Designdatenbank verknüpft sind, mit den Koordinaten des Ausführungsbauteils und der Form des Ausführungsbauteils, die in der Datenbank für korrigierte Baupläne aufgezeichnet sind, zu überschreiben.

11. Verwaltungssystem nach einem der Ansprüche 8 oder 9, ferner umfassend:
eine Übertragungseinheit des korrigierten Bauplans, die dazu konfiguriert ist, das Ausführungsbauteil, die Koordinaten des Ausführungsbauteils und die Form des Ausführungsbauteils, die in der Datenbank für korrigierte Baupläne aufgezeichnet sind, neu in die Designdatenbank hinzuzufügen.

12. Verwaltungssystem nach einem der Ansprüche 8 bis 11, wobei die Erstellungseinheit des korrigierten Modells dazu konfiguriert ist, die Form und/oder die Koordinaten des Designmodells entsprechend einer Form des Messmodells so zu korrigieren, dass keine Kollision entsteht.

13. Verwaltungssystem nach einem der Ansprüche 8 bis 11, wobei die Erstellungseinheit des korrigierten Modells dazu konfiguriert ist, die Form und/oder die Koordinaten des Designmodells auf der Grundlage von Baufehlerinformationen der Messdaten entsprechend einer Form des Messmodells zu korrigieren.

## Revendications

1. Procédé de gestion dans lequel,
en transmettant et en recevant des informations vers et depuis des bases de données, les bases de données incluant :
une base de données de conception (21) enregistrant des données de conception d'éléments de construction constituant un objet de construction, une base de données de mesure (22) enregistrant des données de mesure des éléments de construction et une base de données de construction (6) stockant des données de construction des éléments de construction, les étapes (A) à (G) suivantes sont mises en œuvre :
une étape (A) de sélection d'un élément de construction à partir de la base de données de construction ;
une étape (B) de création d'un modèle de conception de l'élément de construction à partir de données de conception de l'élément de construction dans la base de données de conception ;
une étape (C) de sélection d'un élément périphérique, périphérique à l'élément de construction, à partir de la base de données de conception ;
une étape (D) de création d'un modèle de mesure de l'élément périphérique à partir de données de mesure de l'élément périphérique dans la base de données de mesure ;
une étape (E) de création d'un modèle de conception corrigé en synthétisant le modèle de conception et le modèle de mesure et en corrigeant la forme et/ou les coordonnées du modèle de conception, conformément à une forme du modèle de mesure ;
une étape (F) de sélection d'un élément de construction désigné pour lequel un plan de construction est corrigé sur la base du modèle de conception corrigé ;
une étape (G) d'enregistrement, relativement à l'élément de construction désigné, de coordonnées et d'une forme du modèle de conception corrigé en tant que coordonnées d'élément de construction désigné et forme d'élément de construction désigné, et de contenu de construction de l'élément de construction désigné en tant que contenu d'inspection de construction, dans une base de données de plans de construction corrigés.

2. Procédé de gestion selon la revendication 1, dans lequel en outre,
en transmettant et en recevant des informations vers et depuis une base de données d'éléments enregistrant des données de base d'élément des éléments de construction,
avant l'étape (E), il est déterminé si l'élément de construction et l'élément périphérique sont des éléments mobiles en se référant à la base de données d'éléments, et lorsqu'il est déterminé que l'élément est immobile, le modèle de conception corrigé est créé à l'étape (E), et lorsqu'il est déterminé que l'élément est mobile, des informations de mobilité de l'élément mobile sont lues à partir de la base de données d'éléments et un modèle mobile de l'élément mobile est créé, et un modèle de conception corrigé est créé en synthétisant le modèle de conception ou le modèle de mesure avec le modèle mobile, et le traitement passe à l'étape (F), et
à l'étape (G), en se référant en outre à la base de données d'éléments, des informations de parties affectées par la construction reposant sur les informations de mobilité de l'élément mobile sont enregistrées dans la base de données de plans de construction corrigés.

3. Procédé de gestion selon la revendication 1 ou 2, comprenant en outre :
une étape d'écriture des coordonnées d'élément de construction désigné et de la forme d'élément de construction désigné de l'élément de construction désigné enregistré dans la base de données de plans de construction corrigés sur des coordonnées d'élément et une forme d'élément liées par des informations d'identification d'élément de l'élément de construction désigné dans la base de données de conception.

4. Procédé de gestion selon l'une quelconque des revendications 1 à 3, comprenant en outre : une étape de nouvel ajout de l'élément de construction désigné, des coordonnées d'élément de construction désigné et de la forme d'élément de construction désigné, enregistrés dans la base de données de plans de construction corrigés, dans la base de données de conception.

5. Procédé de gestion selon l'une quelconque des revendications 1 à 4, dans lequel, à l'étape (E), la forme et/ou les coordonnées du modèle de conception sont corrigées conformément à une forme du modèle de mesure pour ne pas créer d'interférence.

6. Procédé de gestion selon l'une quelconque des revendications 1 à 4, dans lequel, à l'étape (E), la forme et/ou les coordonnées du modèle de conception sont corrigées conformément à une forme du modèle de mesure sur la base d'informations d'erreur de construction des données de mesure.

7. Programme de gestion décrivant le procédé de gestion selon l'une quelconque des revendications 1 à 6 en tant que programme informatique et permettant l'exécution du procédé de gestion.

8. Système de gestion comprenant :
une base de données de conception (21) enregistrant des données de conception d'éléments de construction constituant un objet de construction ;
une base de données de mesure (22) enregistrant des données de mesure des éléments de construction ;
une base de données de construction (6) stockant des données de construction des éléments de construction ;
une unité (5) de sélection d'élément de construction configurée pour sélectionner un élément de construction à partir de la base de données de construction ;
une unité (8) de sélection d'élément périphérique configurée pour sélectionner un élément périphérique, périphérique à l'élément de construction, à partir de la base de données de conception ;
une unité (9) de création de modèle configurée pour créer un modèle de conception de l'élément de construction à partir des données de conception de l'élément de construction, et un modèle de mesure de l'élément périphérique à partir des données de mesure de l'élément périphérique ;
une unité (12) de création de modèle corrigé configurée pour créer un modèle de conception corrigé en synthétisant le modèle de conception et le modèle de mesure et en corrigeant la forme et/ou les coordonnées du modèle de conception, conformément à une forme du modèle de mesure ; et
une unité (11) de création de plan de construction corrigé configurée pour sélectionner un élément de construction désigné pour lequel un plan de construction est corrigé sur la base du modèle de conception corrigé, et enregistrer, relativement à l'élément de construction désigné, des coordonnées et une forme du modèle de conception corrigé en tant que coordonnées d'élément de construction désigné et forme d'élément de construction désigné, et du contenu de construction de l'élément de construction désigné en tant que contenu d'inspection de construction, dans une base de données de plans de construction corrigés (12).

9. Système de gestion selon la revendication 8, comprenant en outre :
une base de données d'éléments enregistrant des données de base d'élément des éléments de construction ; et
une unité de détermination de mobilité d'élément configurée pour déterminer si l'élément de construction et l'élément périphérique sont des éléments mobiles en se référant à la base de données d'éléments, et lorsqu'il est déterminé que l'élément est mobile, lire des informations de mobilité de l'élément mobile à partir de la base de données d'éléments et créer un modèle mobile de l'élément mobile, dans lequel
l'unité de création de modèle corrigé crée un modèle de conception corrigé en synthétisant le modèle de conception ou le modèle de mesure avec le modèle mobile, et
l'unité de création de plan de construction corrigé se réfère à la base de données d'éléments et enregistre en outre des informations de parties affectées par la construction reposant sur les informations de mobilité de l'élément mobile dans la base de données de plans de construction corrigés.

10. Système de gestion selon la revendication 8 ou 9, comprenant en outre :
une unité de prise en compte de plan de construction corrigé configurée pour écrire les coordonnées d'élément de construction désigné et la forme d'élément de construction désigné de l'élément de construction désigné enregistré dans la base de données de plans de construction corrigés sur des coordonnées d'élément et une forme d'élément liées par des informations d'identification d'élément de l'élément de construction désigné dans la base de données de conception.

11. Système de gestion selon l'une quelconque des revendications 8 ou 9, comprenant en outre : une unité de prise en compte de plan de construction corrigé configurée pour nouvellement ajouter l'élément de construction désigné, les coordonnées d'élément de construction désigné et la forme d'élément de construction désigné, enregistrés dans la base de données de plans de construction corrigés, dans la base de données de conception.

12. Système de gestion selon l'une quelconque des revendications 8 à 11, dans lequel l'unité de création de modèle corrigé est configurée pour corriger la forme et/ou les coordonnées du modèle de conception conformément à une forme du modèle de mesure pour ne pas créer d'interférence.

13. Système de gestion selon l'une quelconque des revendications 8 à 11, dans lequel l'unité de création de modèle corrigé est configurée pour corriger la forme et/ou les coordonnées du modèle de conception conformément à une forme du modèle de mesure sur la base d'informations d'erreur de construction des données de mesure.
